# EUROPÄISCHE PATENTANMELDUNG

(11) **EP 1 280 391 A1**
(43) Veröffentlichungstag der Anmeldung: **29.01.2003**
(21) Anmeldenummer: 02016491.9
(22) Anmeldetag: 23.07.2002
(51) Int. Cl.: H05K 1/14, H05K 7/02, H05K 7/14

(54) **Programmgesteuerte Einheit mit gestapelten Elementen**

(30) Priorität: 26.07.2001 DE 10136395
(71) Anmelder: Infineon Technologies AG, 81669 München (DE)
(72) Erfinder: Roedi, Herbert, 93073 Neutraubling (DE); Bendel, Klaus, 24107 Quarnbek-Stampe (DE); Vittorelli, Boris, 85778 Haimhausen (DE)
(74) Vertreter: Repkow, Ines, Dr. Dipl.-Ing.

(57) **Zusammenfassung**

Die beschriebene programmgesteuerte Einheit zeichnet sich dadurch aus, daß sie mehrere Halbleiter-Chips umfaßt, und daß die mehreren Halbleiter-Chips auf mehrere übereinander angeordnete und über einen Bus miteinander verbundene Chip-Träger verteilt sind. Derartige programmgesteuerte Einheiten lassen sich auch dann, wenn sie an spezielle Bedürfnisse angepaßt werden müssen, einfach, schnell und kostengünstig entwickeln, herstellen und testen.

## Beschreibung

Die vorliegende Erfindung betrifft eine Vorrichtung gemäß dem Oberbegriff des Patentanspruchs 1, d.h. eine programmgesteuerte Einheit.

Programmgesteuerte Einheiten wie beispielsweise Mikroprozessoren, Mikrocontroller, und Signalprozessoren sind seit vielen Jahren in unzähligen Ausführungsformen bekannt und bedürfen keiner näheren Erläuterung.

Programmgesteuerte Einheiten zeichnen sich im allgemeinen dadurch aus, daß sie äußerst vielfältig einsetzbar sind. Dies hat den positiven Effekt, daß sie in sehr großen Stückzahlen hergestellt und verkauft werden können, wodurch deren Preis - gemessen am erforderlichen Entwicklungs- und Herstellungsaufwand und der Leistungsfähigkeit - relativ gering ist.

Allerdings sind die verfügbaren programmgesteuerten Einheiten für bestimmte Anwendungen nicht oder nur bedingt geeignet. In solchen Fällen kommt man nicht umhin, speziell auf die jeweiligen Bedürfnisse zugeschnittene programmgesteuerte Einheiten zu entwickeln und herzustellen.

Die Entwicklung, die Herstellung, und das Testen solcher programmgesteuerter Einheiten ist jedoch - unter anderem wegen der relativ geringen Stückzahlen, in welchen diese benötigt werden - unverhältnismäßig aufwendig und teuer.

Der vorliegenden Erfindung liegt daher die Aufgabe zugrunde, eine programmgesteuerte Einheit zu schaffen, die sich auch dann, wenn sie an spezielle Bedürfnisse angepaßt werden muß, einfach, schnell und kostengünstig entwickeln, herstellen und testen läßt.

Diese Aufgabe wird erfindungsgemäß durch die im kennzeichnenden Teil des Patentanspruchs 1 beanspruchten Merkmale gelöst.

Demnach zeichnet sich die erfindungsgemäße programmgesteuerte Einheit dadurch aus, daß die programmgesteuerte Einheit mehrere Halbleiter-Chips umfaßt, und daß die mehreren Halbleiter-Chips auf mehrere übereinander angeordnete und über einen Bus miteinander verbundene Chip-Träger verteilt sind.

Die Verteilung der programmgesteuerten Einheit auf mehrere Halbleiter-Chips ermöglicht es,
- daß die einzelnen Komponenten der programmgesteuerten Einheit einzeln und unabhängig voneinander und mithin vergleichsweise schnell und einfach entwickelt, hergestellt und getestet werden können,
- daß bei der Entwicklung und beim Testen weniger Rücksicht auf Wechselwirkungen zwischen den einzelnen Komponenten der programmgesteuerten Einheit genommen werden muß,
- daß keine Notwendigkeit besteht, Komponenten, die nach unterschiedlichen Verfahren hergestellt werden müssen oder vorzugsweise nach unterschiedlichen Verfahren hergestellt werden, auf dem selben Halbleiter-Chip unterzubringen,
- daß die einzelnen Komponenten der programmgesteuerten Einheit unabhängig voneinander unter Verwendung des jeweils optimalen Herstellungsverfahrens hergestellt werden können,
- daß die programmgesteuerte Einheit allein durch eine entsprechende Auswahl der diese bildenden Halbleiter-Chips an die individuellen Bedürfnisse angepaßt werden kann, und
- daß dann, wenn ein hierzu benötigter Halbleiter-Chip nicht vorhanden ist, nur dieser eine Halbleiter-Chip neu entwickelt werden muß (die restlichen Halbleiter-Chips der programmgesteuerten Einheit können unverändert weiterbenutzt werden).

Die Anordnung der Halbleiter-Chips auf übereinander angeordneten und über einen Bus miteinander verbundenen Chip-Trägern ermöglicht es,
- daß der prinzipielle Aufbau der programmgesteuerten Einheit unabhängig von der Anzahl, den Funktionen, und den Eigenschaften der Halbleiter-Chips stets gleich ist,
- daß das Ersetzen eines Halbleiter-Chips durch einen anderen Halbleiter-Chip und/oder die Erhöhung oder die Verringerung der Anzahl der Halbleiter-Chips jederzeit problemlos (ohne signifikante Änderungen) möglich ist, und
- daß es problemlos möglich ist, die Anzahl und die Lage der Ein- und/oder Ausgabeanschlüsse der programmgesteuerten Einheit unabhängig von der Anzahl und der Art der Halbleiter-Chips unverändert beizubehalten.

Durch den besonderen Aufbau der erfindungsgemäßen programmgesteuerten Einheit
- läßt sich diese einfacher, schneller und kostengünstiger entwickeln, herstellen, und testen als es bei einer auf einem einzigen Halbleiter-Chip untergebrachten programmgesteuerten Einheit der Fall ist, und
- kann eine beispielsweise durch Verwendung zusätzlicher oder anderer Halbleiter-Chips verbesserte oder modifizierte programmgesteuerte Einheit ohne Veränderung des Systems, insbesondere ohne Veränderung des Layouts des Systems, in welchem sie eingesetzt wird, verwendet werden.

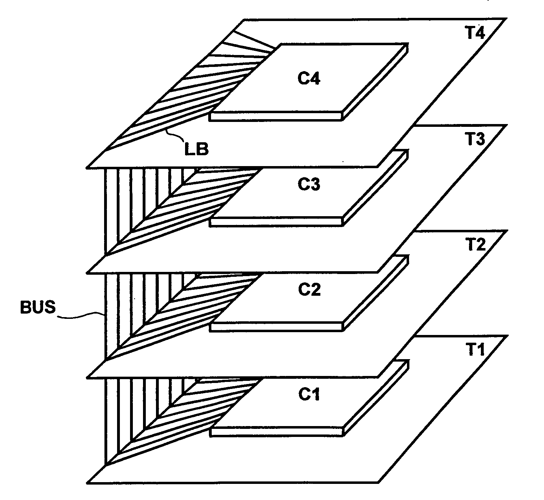

Vorteilhafte Weiterbildungen der Erfindung sind den Unteransprüchen, der folgenden Beschreibung und der Figur entnehmbar.

Die Erfindung wird nachfolgend anhand eines Ausführungsbeispiels unter Bezugnahme auf die Figur näher erläutert.

Die Figur zeigt schematisch den Aufbau der nachfolgend näher beschriebenen programmgesteuerten Einheit.

Die im folgenden beschriebene programmgesteuerte Einheit zeichnet sich dadurch aus, daß sie mehrere Halbleiter-Chips umfaßt, und daß die mehreren Halbleiter-Chips auf mehrere übereinander angeordnete und über einen Bus miteinander verbundene Chip-Träger verteilt sind.

Im betrachteten Beispiel umfaßt die programmgesteuerte Einheit vier Halbleiter-Chips, die jeweils auf einem eigenen Chip-Träger angeordnet sind. Es sei jedoch bereits an dieser Stelle darauf hingewiesen, daß die programmgesteuerte Einheit prinzipiell beliebig viele Halbleiter-Chips enthalten kann, die auf beliebig viele Chip-Träger verteilt sein können. Dabei können auf einem Chip-Träger auch mehrere Halbleiter-Chips angeordnet sein. Auf den Chip-Trägern können außer den Halbleiter-Chips auch andere elektrische, elektronische, elektromechanische Bauteile, beispielsweise Widerstände, Kondensatoren, Spulen, Sensoren, Anzeigevorrichtungen, eventuell sogar Lautsprecher und dergleichen, Lüfter, etc. vorgesehen sein. Die programmgesteuerte Einheit kann auch Trägerelemente umfassen, die keinen Halbleiter-Chip, sondern nur Bauteile der soeben genannten Art, und/oder besondere Verdrahtungen, und/oder Abschirmeinrichtungen (zur Abschirmung elektromagnetischer Felder), und/oder Isolationseinrichtungen (zum Schutz vor zu hohen Temperaturen) etc. enthalten.

Die Halbleiter-Chips sind in der Figur mit den Bezugszeichen C1 bis C4 bezeichnet, die die Halbleiter-Chips tragenden Chip-Träger mit den Bezugszeichen T1 bis T4, und der die Chip-Träger T1 bis T4 elektrisch miteinander verbindende Bus mit dem Bezugszeichen BUS

Im betrachteten Beispiel handelt es sich beim Halbleiter-Chip C1 um einen als Programmspeicher verwendeten Flash-Speicher, beim Halbleiter-Chip C2 um den die auszuführenden Befehle ausführenden Core der programmgesteuerten Einheit, beim Halbleiter-Chip C3 um einen als Datenspeicher verwendeten DRAM-Speicher, und beim Halbleiter-Chip C4 um einen eine Vergleichseinrichtung enthaltenden Halbleiter-Chip.

Wie später noch besser verstanden werden wird, kann die Reihenfolge, in welcher die Halbleiter-Chips (die die Halbleiter-Chips tragenden Chip-Träger) übereinander angeordnet sind, auch beliebig anders festgelegt werden. Bestimmte Umstände können allerdings eine ganz bestimmte Reihenfolge erforderlich machen. Beispielsweise kann es erforderlich sein, daß bestimmte Halbleiter-Chips direkt übereinander oder jedenfalls nicht zu weit voneinander entfernt angeordnet werden und/oder daß bestimmte Halbleiter-Chips ganz oben oder ganz unten im Stapel angeordnet werden, wobei ersteres beispielsweise erforderlich sein kann, wenn geringe maximale Signallaufzeiten nicht überschritten werden dürfen, und wobei letzteres beispielsweise erforderlich sein kann, weil der oben oder unten anzuordnende Halbleiter-Chip besonders heiß wird.

Die Halbleiter-Chips C1 bis C4 sind elektrisch und mechanisch mit den jeweiligen Chip-Trägern T1 bis T4 verbunden. Sie sind beispielsweise auf die Chip-Träger T1 bis T4 aufgeklebt und durch Bonden elektrisch mit den Chip-Trägern verbunden, oder unter Verwendung der Flip-Chip-Technik auf den Chip-Trägern montiert.

Die Chip-Träger T1 bis T4 sind beispielsweise aus Keramik oder Glas bestehende plättchenförmige Gebilde und weisen auf ihrer die Halbleiter-Chips tragenden Oberfläche elektrisch leitende Strukturen auf. Diese elektrisch leitenden Strukturen umfassen (in der Figur nicht gezeigte) Kontaktstellen zur elektrischen Verbindung mit den (durch Pads, Balls, etc. gebildeten) Ein- und/oder Ausgabeanschlüssen der Halbleiter-Chips, und Leiterbahnen LB, die von den Kontaktstellen zum seitlichen Rand der Chip-Träger verlaufen; die Leiterbahnen LB erstrecken sich bis an die Kante der Chip-Träger T1 bis T4, so daß sie bei der Herstellung der (seitlich am Chip-Träger-Stapel verlaufenden) Leitungen des Busses BUS automatisch, d.h. ohne eine spezielle Verbindung mit diesen in Kontakt kommen.

Die Leiterbahnen LB weisen vorzugsweise einen solchen Verlauf auf, daß diejenigen Leiterbahnen, die mit der selben Busleitung zu verbinden sind, den Rand der Chip-Träger an genau übereinander liegenden Stellen der Chip-Träger erreichen; dadurch kann erreicht werden, daß der Bus BUS unabhängig von der Art und der Anzahl der Halbleiter-Chips und unabhängig von der Anordnung der Halbleiter-Chips innerhalb des Chip-Träger-Stapels stets den selben Aufbau und den selben Verlauf aufweisen kann.

Im betrachteten Beispiel werden die Halbleiter-Chips so entworfen und auf die Chip-Träger montiert, daß die Leiterbahnen LB so geführt werden können, daß sie einander nicht überkreuzen. Dadurch kann die auf dem Chip-Träger vorgesehene elektrisch leitende Struktur einlagig, also sehr einfach ausgebildet werden. Prinzipiell könnte die auf dem Chip-Träger vorgesehene elektrisch leitende Struktur aber auch mehrlagig ausgebildet sein; in letzterem Fall sind die Chip-Träger vorzugsweise mehrere Leiterbahnebenen enthaltende, mehrlagig aufgebaute Chip-Träger. Bei Bedarf kann der Entwurf der Halbleiter-Chips auch so erfolgen, daß die Länge bestimmter oder aller Leiterbahnen LB minimal ist und/oder sich möglichst wenig Wechselwirkungen zwischen den Leiterbahnen ergeben.

Die Zwischenräume zwischen den die Halbleiter-Chips C1 bis C4 tragenden Chip-Trägern T1 bis T4 sind mit einer in der Figur nicht gezeigten Füllmasse ausgefüllt. Dadurch wird die Anordnung zu einem etwa quaderförmigen Gebilde. Die Seitenflächen der Chip-Träger, zumindest aber diejenigen Bereiche der Seitenflächen, an welchen die Leiterbahnen LB diese erreichen, bleiben unbedeckt. Dies, und daß die Anordnung genau die gewünschte Form aufweist, wird am einfachsten dadurch erreicht, daß sie aus einer größeren, vorzugsweise mehrere programmgesteuerte Einheiten der beschriebenen Art enthaltenden Anordnung herausgeschnitten wird. Es ist jedoch auch möglich, die Seitenflächen nachträglich freizulegen.

Auf einer, mehreren, oder allen vertikalen Seitenflächen des Quaders werden den bereits erwähnten Bus BUS bildende (Bus-) Leitungen aufgebracht. Diese Busleitungen werden im betrachteten Beispiel dadurch hergestellt, daß auf die mit den Busleitungen versehenden Flächen (beispielsweise durch Sputtern und anschließendes Galvanisieren) eine Metallschicht aufgebracht wird, und daß die nicht benötigten Teile dieser Metallschicht (beispielsweise durch Lasern oder durch selektives Wegätzen) entfernt werden. Die übrig bleibenden Busleitungen verlaufen im betrachteten Beispiel parallel zueinander vertikal von oben nach unten. Sie kommen dabei mit den in die Seitenflächen der Chip-Träger mündenden Leiterbahnen LB in Kontakt und verbinden dadurch die einander zugeordneten Leiterbahnen der verschiedenen Chip-Träger miteinander.

Die programmgesteuerte Einheit oder "nur" der Bus BUS können (müssen aber nicht) mit einem Schützenden Material, beispielsweise einer sogenannten Moldmasse übergossen oder umspritzt werden.

Die Ein- und/oder Ausgabeanschlüsse der programmgesteuerten Einheit zur Verbindung der programmgesteuerten Einheit mit anderen Komponenten eines diese enthaltenden Systems befinden sich auf der Unterseite des untersten Chip-Trägers T1 oder auf einem vorzugsweise die Größe eines Chipträgers aufweisenden separaten Trägerelement, welches unterhalb des untersten Chip-Trägers T1 oder oberhalb des obersten Chip-Trägers T4 angeordnet ist, und welches über den Bus BUS mit den Chip-Trägern T1 bis T4 (den darauf vorgesehen Halbleiter-Chips C1 bis C4 verbunden ist.

Die Ein- und/oder Ausgabeanschlüsse enthalten im betrachteten Beispiel keine Anschlüsse zur Verbindung mit einem externen Speicher. Dies ist nicht erforderlich, weil der benötigte Speicher unabhängig von der Art des benötigten Speichers und unabhängig von der benötigten Speicherkapazität problemlos in die programmgesteuerte Einheit integriert werden kann.

Dadurch reduziert sich die Anzahl der Ein- und/oder Ausgabeanschlüsse der programmgesteuerten Einheit und entfallen die Probleme, die sich aus einer gegebenenfalls erforderlichen Anpassung der programmgesteuerten Einheit an einen externen Speicher ergeben können.

Selbstverständlich ist es bei Bedarf auch möglich, die programmgesteuerte Einheit mit Ein- und/oder Ausgabeanschlüssen für externe Speicher auszustatten.

Programmgesteuerte Einheiten der beschriebenen Art lassen sich unabhängig von den Einzelheiten der praktischen Realisierung auch dann, wenn sie an spezielle Bedürfnisse angepaßt werden müssen, einfach, schnell und kostengünstig entwickeln, herstellen und testen.

### Bezugszeichenliste

- BUS: Bus
- C1 - C4: Halbleiter-Chips
- LB: Leiterbahnen auf T1 bis T4
- T1 - T4: Chip-Träger

## Patentansprüche

1. Programmgesteuerte Einheit,
**dadurch gekennzeichnet,**
**daß** die programmgesteuerte Einheit mehrere Halbleiter-Chips (C1 bis C4) umfaßt, und daß die mehreren Halbleiter-Chips auf mehrere übereinander angeordnete und über einen Bus (BUS) miteinander verbundene Chip-Träger (T1 bis T4) verteilt sind.

2. Programmgesteuerte Einheit nach Anspruch 1,
**dadurch gekennzeichnet,**
**daß** auf den Chip-Trägern (T1 bis T4) elektrisch leitende Strukturen vorgesehen sind, welche Kontaktstellen zur Verbindung mit den Ein- und/oder Ausgabeanschlüssen der darauf montierten Halbleiter-Chips (C1 bis C4), und von den Kontaktstellen an den seitlichen Rand der Chip-Träger verlaufende Leiterbahnen (LB) umfassen.

3. Programmgesteuerte Einheit nach Anspruch 2,
**dadurch gekennzeichnet,**
**daß** die auf den verschiedenen Chip-Trägern (T1 bis T4) vorgesehenen Leiterbahnen (LB) zumindest teilweise über den Bus (BUS) miteinander verbunden werden.

4. Programmgesteuerte Einheit nach einem der vorhergehenden Ansprüche,
**dadurch gekennzeichnet,**
**daß** der Bus (BUS) durch eine Vielzahl von seitlich am Chip-Träger-Stapel verlaufenden Busleitungen gebildet wird.

5. Programmgesteuerte Einheit nach Anspruch 4,
**dadurch gekennzeichnet,**
**daß** die den Bus (BUS) bildenden Busleitungen vertikal verlaufen.

6. Programmgesteuerte Einheit nach Anspruch 4 oder 5,
**dadurch gekennzeichnet,**
**daß** die den Bus (BUS) bildenden Busleitungen parallel zueinander verlaufen.

7. Programmgesteuerte Einheit nach einem der vorhergehenden Ansprüche,
**dadurch gekennzeichnet,**
**daß** die Zwischenräume zwischen den Chip-Trägern (T1 bis T4) mit einer Füllmasse ausgefüllt sind.

8. Programmgesteuerte Einheit nach einem der Ansprüche 3 bis 7,
**dadurch gekennzeichnet,**
**daß** die auf den Chip-Trägern (T1 bis T4) vorgesehenen Leiterbahnen (LB) und die Busleitungen so ausgebildet und angeordnet werden, daß sie bei der Herstellung der Busleitungen ohne eine spezielle Verbindung automatisch miteinander in Kontakt kommen.

9. Programmgesteuerte Einheit nach einem der Ansprüche 3 bis 8,
**dadurch gekennzeichnet,**
**daß** die Leiterbahnen (LB) einen solchen Verlauf aufweisen, daß diejenigen Leiterbahnen, die mit der selben Busleitung zu verbinden sind, den Rand der Chip-Träger (T1 bis T4) an genau übereinander liegenden Stellen erreichen.

10. Programmgesteuerte Einheit nach einem der vorhergehenden Ansprüche,
**dadurch gekennzeichnet,**
**daß** die Ein- und/oder Ausgabeanschlüsse der programmgesteuerten Einheit keine Ein- und/oder Ausgabeanschlüsse zur Verbindung mit einem externen Speicher aufweisen.
